# FASCICULE DE BREVET EUROPEEN

(11) **EP 2 781 023 B1**
(45) Date de publication et mention de la délivrance du brevet: **15.05.2019**
(21) Numéro de dépôt: 12794440.3
(22) Date de dépôt: 06.11.2012
(51) Int. Cl.: H03K 17/567, H05B 41/00, H02M 7/06, H02M 7/155, H02M 7/217, H05B 39/08

(54) **VARIATEUR DE PUISSANCE**
LEISTUNGSVARIATOR
POWER SHIFTER

(30) Priorité: 15.11.2011 FR 1160367
(43) Date de publication de la demande: 24.09.2014
(73) Titulaire: STMicroelectronics (Tours) SAS, 37100 Tours (FR)
(72) Inventeur: RENARD, Benoît, F-37540 Saint-Cyr-sur-Loire (FR); GONTHIER, Laurent, F-37000 Tours (FR)
(74) Mandataire: Cabinet Beaumont
(86) Numéro de dépôt international: PCT/FR2012/052555
(87) Numéro de publication internationale: WO 2013/072602

(56) Documents cités:
- GB-A- 2 435 724
- JP-A- 2001 250 699
- JP-A- 2001 338 789
- US-A- 4 546 308

## Description

### Domaine de l'invention

La présente invention concerne de façon générale les circuits électroniques. Elle vise plus particulièrement le domaine des variateurs de puissance destinés à commander une charge (par exemple un dispositif d'éclairage) alimentée à partir d'une tension alternative (généralement la tension secteur du réseau de distribution électrique).

### Exposé de l'art antérieur

Parmi les variateurs de puissance connus, certains utilisent un triac en série avec la charge, le tout recevant la tension alternative d'alimentation, et un microcontrôleur pour commander le triac. Un exemple pour un circuit d' éclairage utilisant des transistors est divulgué dans le document JP2001250699.

Pour alimenter le microcontrôleur, le variateur comprend généralement un circuit fournissant une tension continue aux bornes d'un condensateur de stockage. Ce circuit comporte par exemple une diode de redressement de la tension alternative pour charger le condensateur, et une diode Zener pour fixer la valeur de la tension continue aux bornes du condensateur.

En fonctionnement, le triac est rendu passant à un stade intermédiaire entre le début et la fin de chaque alternance positive et/ou négative de la tension d'alimentation, par application d'une impulsion de déclenchement sur sa gâchette. Une fois déclenché, le triac reste passant jusqu'à la fin de l'alternance en cours. En jouant sur l'instant d'application de l'impulsion de déclenchement, il est possible de réguler la puissance fournie à la charge. En particulier, un déclenchement en début d'alternance de la tension d'alimentation revient à fournir une puissance plus importante qu'un déclenchement en fin d'alternance.

Un des problèmes liés à l'utilisation d'un triac réside dans le fait que les commutations sont relativement brutales, et sont donc susceptibles de provoquer des gradients de courant et/ou de tension indésirables (par exemple des pics de courant et/ou de tension) aux bornes du triac ou de la charge. Pour éviter la propagation de ces gradients sur le réseau de distribution électrique, il est nécessaire de prévoir un filtre LC entre le triac et des bornes de connexion au réseau du variateur, ce qui augmente l'encombrement et le prix de revient du variateur.

Le filtre LC peut en outre conduire à des dysfonctionnements du variateur. En effet, si le filtre LC permet d'atténuer l'amplitude des perturbations parasites lors des commutations du triac, il provoque en contrepartie, pendant un bref moment après chaque commutation du triac, des oscillations localisées du courant traversant le triac. Il peut arriver que de telles oscillations, lorsqu'elles se produisent après une commutation de l'état bloqué vers l'état passant, se poursuivent pendant une durée supérieure à la durée d'application de l'impulsion de déclenchement à la gâchette du triac. Il existe alors un risque que le courant traversant le triac s'annule temporairement du fait des oscillations, entraînant le blocage du triac presque immédiatement après son déclenchement (décrochage du triac). La charge ne reçoit alors pas la puissance prescrite pendant l'alternance considérée.

Un autre inconvénient lié au filtre LC est que l'inductance peut émettre un bruit acoustique indésirable (grésillement) à chaque fois qu'elle est soumise à une variation de courant importante, c'est-à-dire à chaque amorçage du triac.

Un autre problème des variateurs utilisant un triac ou un autre composant de puissance commandé par un microprocesseur est lié à l'alimentation du microcontrôleur. Dans le cas d'un variateur utilisant un triac, au début de chaque alternance (positive et/ou négative) de la tension alternative d'alimentation, bien qu'aucun courant ne circule dans le triac (ce dernier n'ayant pas encore été déclenché), il circule malgré tout un courant dans le variateur, tiré par le circuit d'alimentation du microcontrôleur pour recharger le condensateur de stockage. Ce courant n'est pas négligeable car à chaque déclenchement du triac, le microcontrôleur doit appliquer sur la gâchette du triac un courant d'intensité relativement importante, par exemple de l'ordre de 5 mA ou plus. Le circuit d'alimentation du microcontrôleur et le condensateur de stockage doivent être dimensionnés en conséquence. Un problème qui se pose est que pour des charges à faible consommation d'énergie, par exemple certaines lampes à diodes électroluminescentes ou certaines lampes fluorescentes compactes de faible puissance (par exemple moins de 10 watts), le courant d'alimentation du microcontrôleur prélevé par le variateur au début de chaque alternance de la tension d'alimentation secteur peut entraîner l'allumage de la charge. Il en résulte qu'en pratique les variateurs utilisant un triac ne peuvent généralement pas être utilisés pour commander des charges de faible puissance. Dans le cas où un composant de puissance autre qu'un triac est commandé par le microcontrôleur, le courant d'alimentation du microcontrôleur n'est pas nécessairement tiré en début d'alternance, mais le même problème se pose.

### Résumé

Ainsi, un objet d'un mode de réalisation de la présente invention est de prévoir un variateur de puissance adapté à commander une charge alimentée par une tension alternative, ce variateur palliant au moins en partie certains des inconvénients des variateurs connus.

Un objet d'un mode de réalisation de la présente invention est de prévoir un variateur de puissance compatible avec des charges à basse consommation d'énergie telles que des lampes à diodes électroluminescentes ou des lampes fluorescentes compactes.

Un autre objet d'un mode de réalisation de la présente invention est de prévoir un procédé de commande d'un variateur de puissance.

Ainsi, un mode de réalisation de la présente invention prévoit un circuit de commande en variation de puissance d'une charge alimentée par une tension alternative, comprenant : un premier thyristor et une première diode en antiparallèle entre des premier et deuxième noeuds, la cathode de la première diode étant côté premier noeud ; un second thyristor et une deuxième diode en antiparallèle entre le deuxième noeud et un troisième noeud, la cathode de la deuxième diode étant côté troisième noeud ; des troisième et quatrième diodes en antisérie entre les premier et troisième noeuds, les cathodes des troisième et quatrième diodes étant reliées à un quatrième noeud ; un transistor entre les deuxième et quatrième noeuds ; et une unité de commande des premier et second thyristors et du transistor et un circuit d'alimentation de l'unité de commande, le circuit d'alimentation étant relié au quatrième noeud d'une part et à une première électrode d'un condensateur de stockage d'autre part, la seconde électrode du condensateur étant reliée au deuxième noeud.

Selon un mode de réalisation de la présente invention, l'unité de commande est configurée pour : à un premier instant d'une alternance de la tension alternative, fermer le transistor ; et à un deuxième instant de l'alternance, postérieur au premier instant, fermer le premier et/ou second thyristor.

Selon un mode de réalisation de la présente invention, le transistor est un transistor à grille isolée.

Selon un mode de réalisation de la présente invention, les premier et second thyristors sont des thyristors à gâchette de cathode.

Selon un mode de réalisation de la présente invention, le transistor est un transistor bipolaire à grille isolée.

Selon un mode de réalisation de la présente invention, les anodes des première et deuxième diodes sont communes et sont directement reliées au deuxième noeud, les cathodes des premier et second thyristors étant communes et reliées au deuxième noeud par l'intermédiaire d'une inductance.

Selon un mode de réalisation de la présente invention, la pente de croissance du courant dans le transistor lors des commutations de ce transistor de l'état bloqué vers l'état passant est comprise entre 50 et 300 ampères par milliseconde.

Selon un mode de réalisation de la présente invention, les premier et second thyristors sont susceptibles d'être déclenchés par un courant de gâchette inférieur à 1 mA.

Selon un mode de réalisation de la présente invention, l'unité de commande comporte des première à troisième bornes de sortie reliées respectivement à la gâchette du premier thyristor, à la gâchette du second thyristor, et à la grille de commande du transistor.

Selon un mode de réalisation de la présente invention, l'unité de commande comporte une première borne de sortie reliée aux gâchettes des premier et second thyristors, et une deuxième borne de sortie reliée à la grille de commande du transistor.

Un autre mode de réalisation de la présente invention prévoit un procédé de commande d'un circuit du type susmentionné, comprenant les étapes suivantes : à un premier instant d'une alternance de la tension alternative, fermer le transistor ; à un deuxième instant de l'alternance, postérieur au premier instant, fermer le premier ou second thyristor.

Selon un mode de réalisation de la présente invention, un signal continu de commande en fermeture est appliqué à l'un des premier et second thyristors à partir du deuxième instant et au moins jusqu'à un instant d'inversion du signe du courant dans la charge.

Selon un mode de réalisation de la présente invention, un signal continu de commande en fermeture est appliqué au premier thyristor et au second thyristor à partir du deuxième instant et au moins jusqu'à un instant d'inversion du signe du courant dans la charge.

Selon un mode de réalisation de la présente invention, 20 à 200 µs séparent le premier instant du deuxième instant.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est un schéma électrique simplifié d'un montage comprenant une charge alimentée par une tension alternative, et un mode de réalisation d'un variateur de puissance adapté à commander la charge ;
les figures 2A à 2E sont des chronogrammes illustrant l'évolution de signaux (tension/courant) en différents points du variateur de la figure 1 ; et
la figure 3 est un chronogramme illustrant de façon plus détaillée l'évolution de signaux (tension/courant) en différents points du variateur de la figure 1.

### Description détaillée

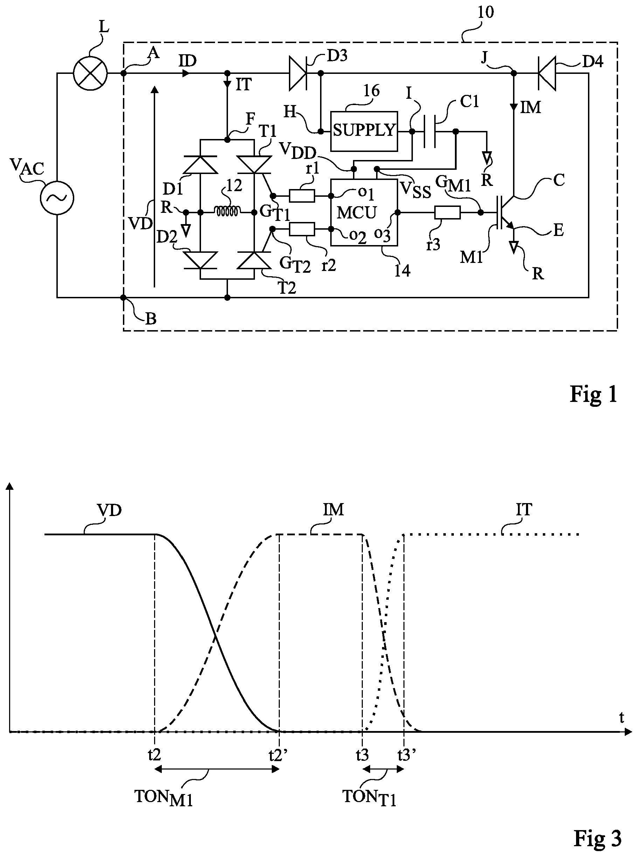

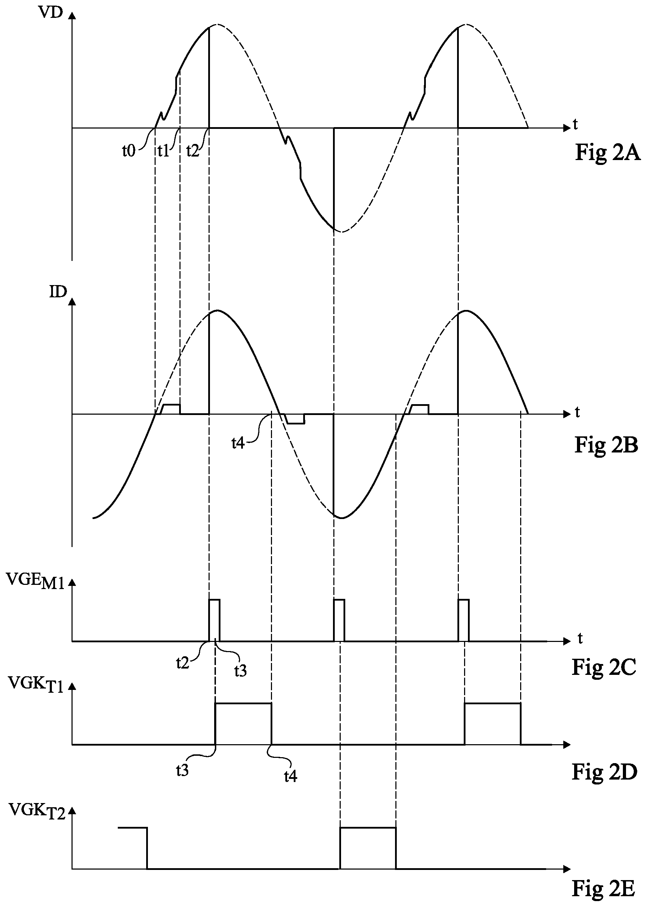

De mêmes éléments ont été désignés par de mêmes références aux différentes figures. Pour des raisons de clarté, seuls les éléments utiles à la compréhension de l'invention ont été représentés sur les figures et seront décrits par la suite. De plus, les figures 2A à 2E et la figure 3 ont été tracées sans respect d'échelle.

La figure 1 est un schéma électrique simplifié d'un montage comprenant une charge L alimentée par une tension alternative V_{AC}, et un exemple d'un mode de réalisation d'un variateur de puissance 10 adapté à commander la charge L.

Dans l'exemple représenté, la charge L est un dispositif d'éclairage, par exemple une ampoule halogène, une lampe à diodes électroluminescentes, une lampe fluorescente compacte, ou tout autre dispositif d'éclairage susceptible d'être alimenté par une tension alternative. La tension alternative V_{AC} est par exemple la tension secteur du réseau de distribution électrique.

Le variateur 10 est monté en série avec la charge L par l'intermédiaire de deux noeuds ou bornes de contact A et B, le tout recevant la tension alternative V_{AC}. Dans l'exemple représenté, la borne A du variateur est connectée à une première borne de la charge L, et la borne B du variateur est connectée à une première borne de fourniture de la tension alternative V_{AC}, une deuxième borne de la charge L étant connectée à une deuxième borne de fourniture de la tension alternative V_{AC}.

Le variateur 10 comprend un thyristor T1 et une diode D1 en antiparallèle entre un noeud F et un noeud R, le noeud F étant relié au noeud A, et le noeud R définissant une référence commune à plusieurs composants du variateur. Dans cet exemple, le thyristor T1 est un thyristor à gâchette de cathode. La cathode de la diode D1 et l'anode du thyristor T1 sont côté noeud F, et l'anode de la diode D1 et la cathode du thyristor T1 sont côté noeud R. Le variateur 10 comprend en outre, entre le noeud R et le noeud B, un thyristor T2, également à gâchette de cathode dans cet exemple, et une diode D2 montée en antiparallèle du thyristor T2. La cathode de la diode D2 et l'anode du thyristor T2 sont côté noeud B, et l'anode de la diode D2 et la cathode du thyristor T2 sont côté noeud R. Les diodes D1 et D2 peuvent être soit des composants discrets, soit des diodes intrinsèques aux thyristors T1 et T2 respectivement.

Dans un mode de réalisation préféré, la cathode de la diode D1 et l'anode du thyristor T1 sont directement connectées au noeud F, le noeud F étant directement connecté au noeud A, et la cathode de la diode D2 et l'anode du thyristor T2 sont directement connectées au noeud B. De plus, l'anode de la diode D1 et l'anode de la diode D2 sont directement connectées au noeud R, et la cathode du thyristor T1 est directement connectée à la cathode du thyristor T2, une inductance 12 reliant les cathodes des thyristors T1 et T2 aux anodes des diodes D1 et D2 (et donc au noeud R).

Parallèlement à la branche comprenant l'inductance 12, les thyristors T1 et T2, et les diodes D1 et D2, le variateur 10 comprend deux diodes D3 et D4 en antisérie entre le noeud A et le noeud B. L'anode de la diode D3 est côté noeud A et l'anode de la diode D4 est côté noeud B, les cathodes des diodes D3 et D4 étant reliées à un même noeud J du variateur. Dans un mode de réalisation préféré, les anodes des diodes D3 et D4 sont directement connectées respectivement au noeud A et au noeud B, et les cathodes des diodes D3 et D4 sont directement connectées au noeud J.

Le variateur 10 comprend en outre un transistor M1 dont les électrodes de conduction sont reliées respectivement au noeud J et au noeud R. Dans un mode de réalisation préféré, les électrodes de conduction du transistor M1 sont directement connectées respectivement au noeud J et au noeud R. Le transistor M1 est de préférence un transistor à grille isolée, par exemple un transistor MOS ou un transistor bipolaire à grille isolée (IGBT). Dans cet exemple, le transistor M1 est un transistor bipolaire à grille isolée (IGBT) dont le collecteur C est relié au noeud J et l'émetteur E est relié au noeud R.

Le variateur 10 comprend par ailleurs une unité de commande 14 (MCU) des thyristors T1 et T2 et du transistor M1, par exemple un microcontrôleur dont des bornes de sortie sont reliées aux gâchettes de contrôle G_{T1} et G_{T2} des thyristors T1 et T2 et à la grille de commande G_{M1} du transistor M1. Dans cet exemple, trois bornes de sortie o₁, o₂, et o₃ de l'unité de commande 14 sont reliées respectivement à la gâchette de cathode G_{T1} du thyristor T1 par l'intermédiaire d'une résistance r1, à la gâchette de cathode G_{T2} du thyristor T2 par l'intermédiaire d'une résistance r2, et à la grille G_{M1} du transistor M1 par l'intermédiaire d'une résistance r3.

Pour alimenter l'unité de commande 14, le variateur 10 comprend un circuit d'alimentation 16 (SUPPLY) fournissant une tension continue aux bornes d'un condensateur de stockage C1. Le circuit d'alimentation 16 est connecté par des première et seconde bornes H et I, respectivement au noeud J et à une première électrode du condensateur C1. La deuxième électrode du condensateur C1 est reliée au noeud de référence commune R du variateur. Des bornes d'alimentation haute V_{DD} et basse V_{SS} de l'unité de commande 14 sont reliées respectivement aux noeuds I et R (c'est-à-dire respectivement à l'électrode positive et à l'électrode négative du condensateur C1). Le circuit 16, dont le détail n'a pas été représenté sur la figure 1, comporte par exemple une diode Zener pour fixer la valeur de la tension continue aux bornes du condensateur C1, les diodes D1, D2, D3 et D4 jouant le rôle de diodes de redressement de la tension alternative V_{AC}. Tout autre circuit d'alimentation apte à fournir une tension continue à l'unité de commande 14 pourra être utilisé.

Les figures 2A à 2E et la figure 3 permettent de mieux comprendre le fonctionnement du variateur 10 de la figure 1.

Les figures 2A à 2E sont des chronogrammes illustrant l'évolution de signaux (tension/courant) en différents points du variateur 10 de la figure 1 lors de son fonctionnement. Les figures 2A et 2B illustrent respectivement l'évolution de la tension VD et du courant ID en entrée du variateur 10, c'est-à-dire entre les bornes A et B. Les figures 2C, 2D et 2E illustrent respectivement l'évolution des tensions VGE_{M1}, VGK_{T1} et VGK_{T2} appliquées par l'unité de commande 14 respectivement entre la grille G_{M1} et l'émetteur E du transistor M1, entre la gâchette de cathode G_{T1} et la cathode du thyristor T1, et entre la gâchette de cathode G_{T2} et la cathode du thyristor T2.

Au début d'une alternance positive de la tension V_{AC}, le transistor M1 et les thyristors T1 et T2 sont maintenus bloqués (tensions VGE_{M1}, VGK_{T1} et VGK_{T2} sensiblement nulles dans cet exemple). Entre un instant t0 de début de l'alternance et un instant t1 postérieur à l'instant t0, il circule dans le variateur 10 un courant ID correspondant au courant tiré par le circuit 16 d'alimentation de l'unité de commande 14 pour recharger le condensateur de stockage C1. Pendant cette période, on observe un léger décrochement de la tension VD aux bornes du variateur, c'est-à-dire que la tension VD reste légèrement inférieure à la tension d'alimentation V_{AC}.

Entre l'instant t1 et un instant intermédiaire t2 compris entre t1 et la fin de l'alternance, le condensateur C1 étant chargé et le transistor M1 et les thyristors T1 et T2 étant toujours bloqués, il ne circule aucun courant dans le variateur 10. La tension VD aux bornes du variateur suit alors fidèlement la tension alternative d'alimentation V_{AC}.

A l'instant t2, le transistor M1 est rendu passant. Pour cela, l'unité de commande 14 applique une tension grille-émetteur VGE_{M1} supérieure à la tension de seuil du transistor. Dès que le transistor M1 devient passant, il circule un courant ID dans le variateur, et donc dans la charge L, passant par la diode D3, le transistor M1, le noeud de référence R, et la diode D2.

A un instant t3, peu après l'instant t2, par exemple 20 à 200 µs après l'instant t2, le thyristor T1 est rendu passant. Pour cela, l'unité de commande 14 applique une tension VGK_{T1} entre la résistance de gâchette de cathode et la cathode du thyristor T1, de manière à appliquer un courant d'intensité supérieure à un seuil de déclenchement entre la gâchette de cathode et la cathode du thyristor. Dès que le thyristor T1 devient passant, la chute de tension aux bornes du thyristor T1 et de la diode D2 étant plus faible que la chute de tension aux bornes de la diode D3, du transistor M1 et de la diode D2, le courant ID circulant dans le variateur cesse de passer par la diode D3, le transistor M1 et la diode D2, et se met à passer par le thyristor T1, l'inductance 12, et la diode D2. Dans cet exemple, peu de temps après l'instant t3, par exemple quelques dizaines à quelques centaines de microsecondes après l'instant t3, le transistor M1 est ouvert (bloqué). Une fois déclenché, le thyristor T1 reste passant jusqu'à la fin de l'alternance. Pour éviter tout risque de décrochage du thyristor T1 dans l'éventualité où un pic de tension parasite conduirait à annuler la tension à ses bornes avant la fin de l'alternance, on peut prévoir de maintenir un signal de commande en fermeture du thyristor T1 (tension VGK_{T1} positive) jusqu'à un instant t4 (postérieur à l'instant t3) proche de la fin de l'alternance. En variante, on peut aussi prévoir de maintenir le signal de commande en fermeture du thyristor T1 jusqu'à la fin de l'alternance ou même jusqu'après la fin de l'alternance (début de l'alternance suivante, voire même jusqu'à peu avant la fin de l'alternance suivante). Ceci permet de garantir que le courant de gâchette soit maintenu jusqu'à ce que le courant circulant dans la charge s'annule, ce qui peut arriver avec un certain retard pour des charges inductives (moteur, etc.).

La séquence susmentionnée est réitérée à chaque alternance positive ou négative de la tension alternative V_{AC}, la seule différence, pour les alternances négatives, étant qu'entre les instants t2 et t3, le thyristor T1 est maintenu bloqué, et c'est le thyristor T2 qui est rendu passant par application d'une tension positive VGK_{T2} entre sa résistance de gâchette de cathode et sa cathode. Pendant les alternances négatives, le courant circulant dans le variateur passe donc par la diode D4, le transistor M1 et la diode D1 entre les instants t2 et t3, et par le thyristor T2 et la diode D1 entre l'instant t3 et la fin de l'alternance.

En jouant sur les instants t2 et t3 de mise en conduction du variateur (via le transistor M1 dans un premier temps puis via le thyristor T1 ou T2 peu de temps après), il est possible de réguler la puissance fournie à la charge L. En particulier, un déclenchement en début d'alternance (t2 proche de t0) revient à fournir à la charge une puissance plus importante qu'un déclenchement en fin d'alternance (t2 proche de la fin de l'alternance).

Un avantage du variateur 10 décrit en relation avec la figure 1 et du procédé de commande de ce variateur décrit en relation avec les figures 2A à 2E, est que les commutations du variateur de l'état non-passant vers l'état passant sont moins brutales que celles d'un variateur utilisant un triac. En effet, dans un transistor à grille isolée (ou autre transistor à amorçage contrôlé), la pente de croissance du courant à la commutation de l'état bloqué vers l'état passant est commandable, et peut être rendue moins raide que dans un triac ou un thyristor. La commande de la pente de croissance peut se faire en contrôlant la vitesse de charge de la tension de grille (pour un transistor MOS), ou la vitesse de variation du courant de base (pour un transistor bipolaire).

Dans le variateur 10, l'étape intermédiaire consistant à rendre passant le transistor M1 avant de rendre passant le thyristor T1 ou T2, permet d'adoucir la commutation, tout en conservant, pendant la majeure partie de la phase de conduction du variateur, l'avantage de faible chute de tension lié à l'utilisation d'un thyristor.

La figure 3 est un chronogramme illustrant plus en détail ce phénomène. La figure 3 représente de façon plus détaillée l'évolution de signaux (tension/courant) en différents points du variateur lors d'une commutation du variateur de l'état bloqué vers l'état passant, pendant une alternance positive de la tension d'alimentation V_{AC}. Plus particulièrement, la figure 3 représente l'évolution, dans le cas d'une charge résistive, de la tension VD aux bornes du variateur (courbe en trait plein), du courant IM dans le transistor M1 (courbe en tirets), et du courant IT dans la branche comprenant les diodes D1 et D2, les thyristors T1 et T2, et l'inductance 12 (courbe en pointillés).

A l'instant t2 (voir les figures 2A à 2E), le transistor M1 est rendu passant. Entre l'instant t2 et un instant t2' postérieur à l'instant t2, le courant IM circulant dans le transistor M1 croit depuis une valeur sensiblement nulle (transistor ouvert) jusqu'à une valeur haute, correspondant sensiblement au courant délivré par la source d'alimentation alternative V_{AC} (transistor fermé) à la charge. Dans le même temps, la tension VD aux bornes du variateur décroît depuis une valeur haute, correspondant sensiblement à la tension d'alimentation alternative V_{AC} (moins éventuellement la chute de tension de la charge), jusqu'à une valeur sensiblement nulle (à la chute de tension de la diode D3 et du transistor M1 près).

A l'instant t3, de préférence postérieur à l'instant t2', et peu après l'instant t2, par exemple 20 à 200 µs après l'instant t2, le thyristor T1 est rendu passant. Entre l'instant t3 et un instant t3' postérieur à l'instant t3, le courant IT circulant dans le thyristor T1 croit depuis une valeur sensiblement nulle jusqu'à une valeur haute, correspondant sensiblement au courant délivré par la source d'alimentation alternative V_{AC}. Dans le même temps, le courant IM circulant dans le transistor M1 décroît depuis une valeur haute jusqu'à une valeur sensiblement nulle.

Comme cela apparaît sur la figure 3, la pente de croissance du courant IM dans le transistor M1 dans l'intervalle TON_{M1} entre les instants t2 et t2', correspondant au temps de commutation du transistor M1 de l'état bloqué vers l'état passant, est nettement plus faible que la pente de croissance du courant IT dans le thyristor T1 dans l'intervalle TON_{T1} entre les instants t3 et t3', correspondant au temps de commutation du thyristor T1 de l'état bloqué vers l'état passant (éventuellement ralenti par l'inductance 12 si elle est présente).

On notera que la pente de croissance du courant dans le transistor M1 peut être réglée, par exemple en jouant sur la valeur de la résistance r3 reliant la grille G_{M1} du transistor M1 à la borne de sortie correspondante o₃ de l'unité de commande 14. Optionnellement, une capacité de l'ordre de 1 à 50 nF peut être connectée entre la grille et l'émetteur du transistor M1 (dans le cas d'un transistor à grille isolée) pour ralentir la commutation. Selon un aspect du mode de réalisation décrit, la pente de croissance du courant dans le transistor M1 est choisie suffisamment faible pour éviter que des pics et gradients parasites de courant/tension susceptibles d'entraîner des perturbations sur le réseau électrique ne se produisent lors des commutations du variateur. On peut alors se passer, en entrée du variateur, d'un filtre LC du type habituellement utilisé dans les variateurs utilisant un triac. A titre d'exemple, la pente de croissance du courant dans le transistor M1 est réglée à une valeur comprise entre 50 et 300 ampères par milliseconde. Par comparaison, la pente de croissance du courant dans les variateurs utilisant un triac est généralement de l'ordre de 10 à 50 ampères par microseconde (en l'absence d'un filtre LC).

On notera que la chute de tension aux bornes du thyristor T1 et de la diode D2 ou aux bornes du thyristor T2 et de la diode D1, est moins importante que la chute de tension aux bornes du transistor M1 et de la diode D3 ou D4. Un rôle de l'inductance 12 est d'absorber le pic de tension susceptible de se produire à l'instant t3, lorsque le courant ID cesse de passer dans le transistor M1 pour circuler dans le thyristor T1 ou T2. En tout état de cause, la valeur de l'inductance 12, par exemple de l'ordre de 1 à 10 µH, est faible par rapport aux inductances des filtres LC habituellement prévus dans les variateurs utilisant un triac, de l'ordre de 1 mH ou plus. En variante, on pourra se passer de l'inductance 12 et connecter directement les cathodes des thyristors T1 et T2 au noeud R (et donc aux anodes des diodes D1 et D2). Dans une autre variante, on pourra prévoir une capacité (non représentée) entre les bornes A et B du variateur (à la place de l'inductance 12 ou en complément de l'inductance 12), pour absorber les pics susceptibles de se produire à la mise en conduction du thyristor T1 ou T2, et/ou immuniser le variateur au bruit du secteur. En tout état de cause, la valeur de cette capacité, par exemple de l'ordre de 1 à 50 nF, est faible par rapport aux capacités des filtres LC habituellement prévus dans les variateurs utilisant un triac.

En d'autres termes, un avantage du mode de réalisation décrit en relation avec les figures 1 à 3 est qu'il permet soit de se passer du filtre LC habituellement prévu dans les variateurs de puissance utilisant un triac, soit de réduire considérablement les dimensions de ce filtre.

D'autres dispositions de l'inductance 12 pourront être envisagées.

Dans un premier exemple, l'inductance 12 peut, comme dans l'exemple décrit en relation avec la figure 1, relier les anodes des diodes D1 et D2 aux cathodes des thyristors T1 et T2, le noeud R étant cette fois directement connecté aux cathodes des thyristors T1 et T2, et non pas aux anodes des diodes D1 et D2.

Dans un deuxième exemple, l'inductance 12 peut être placée entre la charge L et le noeud A.

Dans un troisième exemple, l'inductance 12 peut être placée entre le noeud F et l'anode du thyristor T1, une deuxième inductance identique ou du même ordre étant placée entre le noeud B et l'anode du thyristor T2.

Dans un quatrième exemple, l'inductance 12 peut être placée entre le noeud F et le noeud A.

Plus généralement, l'homme du métier saura prévoir d'autres dispositions adaptées de l'inductance 12, étant entendu que l'inductance 12, si elle est prévue, doit être positionnée sur le chemin du courant circulant dans le variateur lorsque la branche comprenant les thyristors T1 et T2 et les diodes D1 et D2 est passante.

Dans un mode de réalisation préféré, les thyristors T1 et T2 sont des thyristors à haute sensibilité, c'est-à-dire qu'ils ne nécessitent qu'un faible courant de gâchette pour leur déclenchement, par exemple un courant inférieur à 1 mA, et de préférence inférieur à 0,5 mA. Par comparaison, les triacs habituellement utilisés dans des variateurs de puissance nécessitent pour leur déclenchement un courant de gâchette de l'ordre de 5 mA ou plus. L'utilisation de thyristors à haute sensibilité permet de réduire de façon significative la consommation d'énergie de l'unité de commande 14. Le variateur 10 peut ainsi être utilisé pour commander des charges à très faible consommation d'énergie, sans que le courant d'alimentation de l'unité de commande 14, circulant dans le variateur au début de chaque alternance de la tension V_{AC}, ne provoque l'allumage de la charge.

L'utilisation de thyristors à haute sensibilité permet en outre d'appliquer un signal continu de commande en fermeture du thyristor T1 ou T2 entre l'instant t3 et l'instant t4 (l'instant t4 pouvant être confondu avec la fin de l'alternance voire même postérieur à la fin de l'alternance), sans pour autant entraîner une surconsommation d'énergie excessive par l'unité de commande 14. Les inventeurs ont constaté qu'en utilisant une commande en fermeture continue (plutôt qu'une commande de type impulsionnelle), le variateur 10 est compatible avec des charges à faible puissance, par exemple inférieure à 10 watts. Par comparaison, l'utilisation d'un signal de commande en fermeture continu dans un variateur utilisant un triac rendrait inévitablement ce variateur incompatible avec des charges de faible ou moyenne puissance, à cause du courant trop important qui serait prélevé pour l'alimentation du circuit de commande du triac.

Un autre avantage est que, du fait de la présence des diodes D3 et D4, le condensateur C1 du variateur 10 peut être chargé pendant les deux alternances, positive et négative, de la tension V_{AC}. Les diodes D3 et D4 permettent par ailleurs de n'utiliser qu'un unique transistor M1 pour commander le variateur pendant les deux alternances, positive et négative de la tension V_{AC}.

Un autre avantage du variateur 10 réside dans la prévision d'une référence flottante R commune au transistor M1, aux thyristors T1 et T2, et à l'unité de commande 14. La prévision d'une telle référence permet de commander les trois interrupteurs M1, T1 et T2 depuis une même unité de commande 14 et en utilisant un unique bloc d'alimentation 16, ce qui permet de réaliser un variateur ne comportant que deux bornes de connexion au réseau électrique, c'est-à-dire un dipôle (le variateur 10 comporte uniquement deux bornes de connexion, l'une étant reliée à une première borne de la charge, et l'autre étant reliée à une première borne d'application de la tension d'alimentation alternative, par exemple la phase, l'autre borne d'application de la tension d'alimentation alternative, par exemple le neutre, étant reliée à une deuxième borne de la charge). En particulier, il n'est donc pas nécessaire de recourir à des composants de type opto-triac, relativement onéreux, pour résoudre des problèmes de référence. On notera que la faible valeur de l'inductance 12 ne perturbe pas de façon significative le potentiel de référence R pour la commande du transistor M1 et des thyristors T1 et T2.

Des modes de réalisation particuliers ont été décrits. Diverses variantes et modifications apparaîtront à l'homme de l'art.

En particulier, les modes de réalisation décrits ne se limitent pas à l'exemple décrit en relation avec la figure 1 dans lequel le transistor M1 est un IGBT. Un transistor MOS ou tout autre transistor à grille isolée pourra être utilisé plutôt qu'un IGBT. Les modes de réalisation décrits ne se limitent pas non plus au cas où le transistor M1 est un transistor à grille isolée. D'autres transistors à amorçage contrôlé, par exemple un transistor bipolaire, pourront être utilisés.

Par ailleurs, les modes de réalisation décrits ne se limitent pas au cas décrit en relation avec la figure 1 dans lequel trois bornes de sortie distinctes de l'unité de commande 14 sont utilisées pour commander le transistor M1 et les thyristors T1 et T2. On pourra prévoir d'utiliser une même borne de sortie du microcontrôleur pour commander les thyristors T1 et T2. Dans ce cas, lors d'une alternance positive, un signal de déclenchement sera appliqué non seulement sur la gâchette du thyristor T1, mais aussi sur celle du thyristor T2. Le thyristor T2 étant polarisé en inverse, il restera bloqué, et le fonctionnement sera identique à celui décrit en relation avec les figures 2A à 2E. Lors d'une alternance négative, un signal de déclenchement sera appliqué non seulement sur la gâchette du thyristor T2, mais aussi sur celle du thyristor T1. Le thyristor T1 étant polarisé en inverse, il restera bloqué, et le fonctionnement sera identique à celui décrit en relation avec les figures 2A à 2E.

En outre, l'homme du métier saura adapter le variateur 10 au cas où le transistor M1 requiert, pour sa commande, un niveau de tension différent (par exemple plus élevé) du niveau de tension requis pour la commande des thyristors T1 et T2. Un élévateur de tension (ou un abaisseur de tension) pourra par exemple être utilisé entre la borne de sortie o₃ du microprocesseur et la grille du transistor M1.

Par ailleurs, bien que les modes de réalisation décrits soient particulièrement avantageux pour commander un dispositif d'éclairage lumineux, ils ne se limitent pas à cette utilisation particulière. Toute autre charge alimentée par une tension alternative pourra être commandée par un variateur du type décrit en relation avec les figures 1 à 3.

De plus, bien que cela n'ait pas été représenté sur la figure 1, le variateur 10 pourra comprendre un ou plusieurs fusibles de protection, par exemple en série avec la charge, entre le noeud A et le noeud commun à l'anode de la diode D3 et à la cathode de la diode D1, ou entre le noeud B et le noeud commun à l'anode de la diode D4 et à la cathode de la diode D2.

## Revendications

1. Circuit de commande en variation de puissance d'une charge alimentée par une tension alternative (V_{AC}), comprenant :
un premier thyristor (T1) et une première diode (D1) en antiparallèle entre des premier (A) et deuxième (R) noeuds, la cathode de la première diode (D1) étant côté premier noeud (A) ;
un second thyristor (T2) et une deuxième diode (D2) en antiparallèle entre le deuxième noeud (R) et un troisième noeud (B), la cathode de la deuxième diode (D2) étant côté troisième noeud (B) ;
des troisième (D3) et quatrième (D4) diodes en antisérie entre les premier (A) et troisième (B) noeuds, les cathodes des troisième (D3) et quatrième (D4) diodes étant reliées à un quatrième noeud (J) ;
un transistor (M1) entre les deuxième (R) et quatrième (J) noeuds ;
une unité de commande (MCU) des premier (T1) et second (T2) thyristors et du transistor (M1) ; et
un circuit (16) d'alimentation de l'unité de commande, le circuit (16) d'alimentation étant relié au quatrième noeud (J) d'une part et à une première électrode d'un condensateur (C1) de stockage d'autre part, la seconde électrode du condensateur (C1) étant reliée au deuxième noeud (R).

2. Circuit selon la revendication 1, dans lequel l'unité de commande est configurée pour :
à un premier instant (t2) d'une alternance de la tension alternative (V_{AC}), fermer le transistor (M1) ; et
à un deuxième instant (t3) de l'alternance, postérieur au premier instant, fermer le premier (T1) et/ou second (T2) thyristor.

3. Circuit selon la revendication 1 ou 2, dans lequel le transistor (M1) est un transistor à grille isolée.

4. Circuit selon l'une quelconque des revendications 1 à 3, dans lequel les premier (T1) et second (T2) thyristors sont des thyristors à gâchette de cathode.

5. Circuit selon l'une quelconque des revendications 1 à 4, dans lequel le transistor (M1) est un transistor bipolaire à grille isolée.

6. Circuit selon l'une quelconque des revendications 1 à 5, dans lequel les anodes des première (D1) et deuxième (D2) diodes sont communes et sont directement reliées au deuxième noeud (R), les cathodes des premier (T1) et second (T2) thyristors étant communes et reliées au deuxième noeud (R) par l'intermédiaire d'une inductance (12).

7. Circuit selon l'une quelconque des revendications 1 à 6, dans lequel la pente de croissance du courant dans le transistor (M1) lors des commutations de ce transistor de l'état bloqué vers l'état passant est comprise entre 50 et 300 ampères par milliseconde.

8. Circuit selon l'une quelconque des revendications 1 à 7, dans lequel les premier (T1) et second (T2) thyristors sont susceptibles d'être déclenchés par un courant de gâchette inférieur à 1 mA.

9. Circuit selon l'une quelconque des revendications 1 à 8, dans lequel l'unité de commande (MCU) comporte des première à troisième (o₁, o₂, o₃) bornes de sortie reliées respectivement à la gâchette (G_{T1}) du premier thyristor (T1), à la gâchette (G_{T2}) du second thyristor (T2), et à la grille (G_{M1}) de commande du transistor (M1).

10. Circuit selon l'une quelconque des revendications 1 à 9, dans lequel l'unité de commande (MCU) comporte une première borne de sortie reliée aux gâchettes (G_{T1}, G_{T2}) des premier et second thyristors (T1, T2), et une deuxième borne de sortie reliée à la grille (G_{M1}) de commande du transistor (M1).

11. Procédé de commande d'un circuit selon l'une quelconque des revendications 1 à 10, comprenant les étapes suivantes :
à un premier instant (t2) d'une alternance de la tension alternative (V_{AC}), fermer le transistor (M1) ;
à un deuxième instant (t3) de l'alternance, postérieur au premier instant, fermer le premier (T1) ou second (T2) thyristor.

12. Procédé selon la revendication 11, dans lequel un signal continu de commande en fermeture est appliqué à l'un des premier (T1) et second (T2) thyristors à partir du deuxième instant (t3) et au moins jusqu'à un instant d'inversion du signe du courant dans la charge.

13. Procédé selon la revendication 12, dans lequel un signal continu de commande en fermeture est appliqué au premier thyristor (T1) et au second thyristor (T2) à partir du deuxième instant (t3) et au moins jusqu'à un instant d'inversion du signe du courant dans la charge.

14. Procédé selon l'une quelconque des revendications 11 à 13, dans lequel 20 à 200 µs séparent le premier instant (t2) du deuxième instant (t3).

## Patentansprüche

1. Schaltung zum Steuern der Leistungsänderung einer Last, die mit einer Wechselspannung (V_{AC}) versorgt wird, die Folgendes aufweist:
einen ersten Thyristor (T1) und eine erste Diode (D1) antiparallel zwischen ersten (A) und zweiten (R) Knoten, wobei die Kathode der ersten Diode (D1) auf der Seite des ersten Knotens (A) liegt;
einen zweiten Thyristor (T2) und eine zweite Diode (D2) antiparallel zwischen dem zweiten Knoten (R) und einem dritten Knoten (B), wobei die Kathode der zweiten Diode (D2) auf der Seite des dritten Knotens (B) liegt;
dritte (D3) und vierte (D4) Dioden antiseriell zwischen den ersten (A) und dritten (B) Knoten, wobei die Kathoden der dritten (D3) und vierten (D4) Dioden mit einem vierten Knoten (J) verbunden sind;
einen Transistor (M1) zwischen den zweiten (R) und vierten (J) Knoten;
eine Steuereinheit (MCU) des ersten (T1) und zweiten (T2) Thyristors und des Transistors (M1); und
eine Schaltung (16) zum Betreiben der Steuereinheit, wobei die Stromversorgungsschaltung (16) einerseits mit dem vierten Knoten (J) und andererseits mit einer ersten Elektrode eines Speicherkondensators (C1) verbunden ist, wobei die zweite Elektrode des Kondensators (C1) mit dem zweiten Knoten (R) verbunden ist.

2. Schaltung nach Anspruch 1, wobei die Steuereinheit für Folgendes konfiguriert ist:
zu einem ersten Zeitpunkt (t2) einer Halbwelle der Wechselspannung (V_{AC}), Einschalten des Transistors (M1); und
zu einem zweiten Zeitpunkt (t3) der Halbwelle, anschließend dem ersten Zeitpunkt, Einschalten des ersten (T1) und/oder des zweiten (T2) Thyristors.

3. Schaltung nach Anspruch 1 oder 2, wobei der Transistor (M1) ein Transistor mit isolierendem Gate ist.

4. Schaltung nach einem der Ansprüche 1 bis 3, wobei die ersten (T1) und zweiten (T2) Thyristoren Kathoden-Gate-Thyristoren sind.

5. Schaltung nach einem der Ansprüche 1 bis 4, wobei der Transistor (M1) ein Bipolar-Transistor mit isoliertem Gate ist.

6. Schaltung nach einem der Ansprüche 1 bis 5, wobei die Anoden der ersten (D1) und zweiten (D2) Dioden gemeinsam sind und direkt mit dem zweiten Knoten (R) verbunden sind, wobei die Kathoden der ersten (T1) und zweiten (T2) Thyristoren gemeinsam sind und über eine Induktivität (12) mit dem zweiten Knoten (R) verbunden sind.

7. Schaltung nach einem der Ansprüche 1 bis 6, wobei die Wachstumsrate des Stroms im Transistor (M1) während des Schaltens dieses Transistors vom Aus-Zustand in den Ein-Zustand zwischen 50 und 300 Ampere pro Millisekunde liegt.

8. Schaltung nach einem der Ansprüche 1 bis 7, wobei die ersten (T1) und zweiten (T2) Thyristoren geeignet sind, mit einem Gate-Strom von weniger als 1 mA gestartet zu werden.

9. Schaltung nach einem der Ansprüche 1 bis 8, wobei die Steuereinheit (MCU) erste bis dritte (o₁, o₂, o₃) Ausgangsanschlüsse aufweist, die jeweils mit dem Gate (G_{T1}) des ersten Thyristors (T1), dem Gate (G_{T2}) des zweiten Thyristors (T2) und dem Steuer-Gate (G_{M1}) des Transistors (M1) verbunden sind.

10. Schaltung nach einem der Ansprüche 1 bis 9, wobei die Steuereinheit (MCU) einen ersten Ausgangsanschluss aufweist, der jeweils mit den Gates (G_{T1}, G_{T2}) der ersten und zweiten Thyristoren (T1, T2) verbunden ist, und einen zweiten Ausgangsanschluss, der mit dem Steuer-Gate (G_{M1}) des Transistors (M1) verbunden ist.

11. Verfahren zum Steuern der Schaltung nach einem der Ansprüche 1 bis 10, das folgende Schritte aufweist:
zu einem ersten Zeitpunkt (t2) einer Halbwelle der Wechselspannung (V_{AC}), Einschalten des Transistors (M1);
zu einem zweiten Zeitpunkt (t3) der Halbwelle, anschließend dem ersten Zeitpunkt, Einschalten der ersten (T1) oder zweiten (T2) Thyristoren.

12. Verfahren nach Anspruch 11, wobei ein Gleichstrom-Einschaltsteuersignal an einen der ersten (T1) und zweiten (T2) Thyristoren vom zweiten Zeitpunkt (t3) und wenigstens bis zu einem Zeitpunkt der Umkehrung des Vorzeichens des Stroms in der Last angelegt wird.

13. Verfahren nach Anspruch 12, wobei ein Gleichstrom-Einschaltsteuersignal an den ersten Thyristor (T1) und an den zweiten Thyristor (T2) ab dem zweiten Zeitpunkt (t3) und wenigstens bis zu einem Zeitpunkt der Umkehrung des Vorzeichens des Stroms in der Last angelegt wird.

14. Verfahren nach einem der Ansprüche 11 bis 13, wobei 20 bis 200 µs den ersten Zeitpunkt (t2) von dem zweiten Zeitpunkt (t3) trennen.

## Claims

1. A circuit for controlling the power variation of a load powered with an A.C. voltage (V_{AC}), comprising:
a first thyristor (T1) and a first diode (D1) in antiparallel between first (A) and second (R) nodes, the cathode of the first diode (D1) being on the side of the first node (A);
a second thyristor (T2) and a second diode (D2) in antiparallel between the second node (R) and a third node (B), the cathode of the second diode (D2) being on the side of the third node (B);
third (D3) and fourth (D4) diodes in antiseries between the first (A) and third (B) nodes, the cathodes of the third (D3) and fourth (D4) diodes being connected to a fourth node (J);
a transistor (M1) between the second (R) and fourth (J) nodes;
a control unit (MCU) of the first (T1) and second (T2) thyristors and the transistor (M1); and
a circuit (16) for powering the control unit, the power supply circuit (16) being connected to the fourth node (J), on the one hand, and to a first electrode of a storage capacitor (C1), on the other hand, the second electrode of the capacitor (C1) being connected to the second node (R).

2. The circuit of claim 1, wherein the control unit is configured for:
at a first time (t2) of a halfwave of the A.C. voltage (V_{AC}), turning on the transistor (M1); and
at a second time (t3) of the halfwave, subsequent to the first time, turning on the first (T1) and/or the second (T2) thyristor.

3. The circuit of claim 1 or 2, wherein the transistor (M1) is an insulated-gate transistor.

4. The circuit of any of claims 1 to 3, wherein the first (T1) and second (T2) thyristors are cathode-gate thyristors.

5. The circuit of any of claims 1 to 4, wherein the transistor (M1) is an insulated-gate bipolar transistor.

6. The circuit of any of claims 1 to 5, wherein the anodes of the first (D1) and second (D2) diodes are common and are directly connected to the second node (R), the cathodes of the first (T1) and second (T2) thyristors being common and connected to the second node (R) via an inductance (12).

7. The circuit of any of claims 1 to 6, wherein the growth rate of the current in the transistor (M1) during switchings of this transistor from the off state to the on state ranges between 50 and 300 amperes per millisecond.

8. The circuit of any of claims 1 to 7, wherein the first (T1) and second (T2) thyristors are capable of being started by a gate current lower than 1 mA.

9. The circuit of any of claims 1 to 8, wherein the control unit (MCU) comprises first to third (o₁, o₂, o₃) output terminals respectively connected to the gate (G_{T1}) of the first thyristor (T1), to the gate (G_{T2}) of the second thyristor (T2), and to the control gate (G_{M1}) of the transistor (M1).

10. The circuit of any of claims 1 to 9, wherein the control unit (MCU) comprises a first output terminal connected to the gates (G_{T1}, G_{T2}) of the first and second thyristors (T1, T2), and a second output terminal connected to the control gate (G_{M1}) of the transistor (M1).

11. A method for controlling the circuit of any of claims 1 to 10, comprising the steps of:
at a first time (t2) of a halfwave of the A.C. voltage (V_{AC}), turning on the transistor (M1);
at a second time (t3) of the halfwave, subsequent to the first time, turning on the first (T1) or second (T2) thyristor.

12. The method of claim 11, wherein a D.C. turn-on control signal is applied to one of the first (T1) and second (T2) thyristors from the second time (t3) and at least until a time of inversion of the sign of the current in the load.

13. The method of claim 12, wherein a D.C. turn-on control signal is applied to the first thyristor (T1) and to the second thyristor (T2) from the second time (t3) and at least until a time of inversion of the sign of the current in the load.

14. The method of any of claims 11 to 13, wherein from 20 to 200 µs separate the first time (t2) from the second time (t3) .
